(19) Europäisches Patentamt / European Patent Office / Office européen des brevets

(11) **EP 4 031 936 B1**

(12) **FASCICULE DE BREVET EUROPEEN**

(45) Date de publication et mention de la délivrance du brevet:
**08.11.2023 Bulletin 2023/45**

(21) Numéro de dépôt: **20771923.8**

(22) Date de dépôt: **15.09.2020**

(51) Classification Internationale des Brevets (IPC):
**G03F 7/00** *(2006.01)*    **B81C 1/00** *(2006.01)*
**G04D 3/00** *(2006.01)*    **G04B 17/06** *(2006.01)*
**G04D 7/10** *(2006.01)*

(52) Classification Coopérative des Brevets (CPC):
**G03F 7/0002; B81C 1/00682; G04B 17/066; G04D 3/0069; G04D 7/10;** B81B 2203/056; B81B 2207/053; B81C 2201/0132

(86) Numéro de dépôt international:
**PCT/IB2020/058551**

(87) Numéro de publication internationale:
**WO 2021/053501 (25.03.2021 Gazette 2021/12)**

(54) **PROCÉDÉ DE FABRICATION D'UNE PLURALITÉ DE RÉSONATEURS SUR UNE PLAQUETTE**

VERFAHREN ZUR HERSTELLUNG EINER MEHRZAHL VON RESONATOREN IN EINEM WAFER

METHOD FOR MANUFACTURING A PLURALITY OF RESONATORS IN A WAFER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.09.2019 CH 11672019**

(43) Date de publication de la demande:
**27.07.2022 Bulletin 2022/30**

(73) Titulaire: **Richemont International S.A.**
**1752 Villars-sur-Glâne (CH)**

(72) Inventeurs:
• **TOBENAS BORRON, Susana del Carmen**
**2017 Boudry (CH)**
• **HERAUD, Alexis**
**25300 Pontarlier (FR)**
• **RIBETTO, Luca**
**38500 Voiron (FR)**
• **WENK, Béatrice**
**38100 Grenoble (FR)**
• **SOCQUET, Nelly**
**38130 Echirolles (FR)**

(74) Mandataire: **e-Patent SA**
**Rue Saint-Maurice 12**
**Case postale**
**2001 Neuchâtel 1 (CH)**

(56) Documents cités:
EP-A1- 2 565 727    EP-A1- 3 285 124
EP-A1- 3 769 160    EP-B1- 2 753 984
EP-B1- 3 769 161    WO-A1-2019/166922
JP-A- 2017 044 533

EP 4 031 936 B1

## Description

### Domaine technique

L'invention concerne un procédé de fabrication d'une pluralité de résonateurs mécaniques sur une plaquette, notamment des résonateurs destinés à équiper un organe régulateur d'une pièce d'horlogerie.

Plus spécifiquement l'invention trouve une application particulièrement avantageuse pour la fabrication d'une pluralité de spiraux sur une plaquette chacun destiné à équiper un balancier d'un ensemble d'horlogerie mécanique telle qu'une montre.

### Etat de la technique

Les mouvements de montres mécaniques sont régulés au moyen d'un régulateur mécanique comprenant un résonateur, c'est-à-dire un composant déformable élastiquement et dont les oscillations déterminent la marche de la montre. De nombreuses montres comportent par exemple un régulateur comprenant un spiral comme résonateur, monté sur l'axe d'un balancier et mis en oscillation grâce à un échappement; la fréquence propre du couple balancier-spiral permet de réguler la montre. D'autres types de résonateurs connus sont basés par exemple sur des diapasons, des barreaux oscillants, ou d'autres éléments mécaniques. On connaît enfin de développements récents l'intégration de résonateurs dans une autre fonction de la montre, comme le propose le document EP2037335, dans lequel ce résonateur revêt une fonction différente du résonateur principal qui régule les oscillations.

La raideur d'un résonateur de type spiral dépend de ses dimensions et en particulier de l'épaisseur (voire la largeur) de ses spires le long de son barreau. La raideur est donnée plus spécifiquement par:

$$K = \frac{M}{\varphi}$$

avec :

$\varphi$, l'angle de torsion du ressort et
$M$, le couple de rappel du ressort spiral

où M, pour un barreau de section constante constitué d'un matériau spécifique, est donné par:

$$M = \frac{E\left(\frac{e^3 h}{12}\varphi\right)}{L}$$

avec :

$E$, le module d'Young du matériau employé pour le barreau,
$L$, la longueur du barreau,
$h$, la hauteur du barreau, et
$e$, l'épaisseur ou la largeur du barreau.

La fréquence propre de résonance du spiral est proportionnelle à la racine carrée de sa raideur. La spécification principale d'un ressort spiral est sa raideur, qui doit se trouver dans un intervalle bien défini pour pouvoir l'appairer avec un balancier, voire l'élément inertiel de l'oscillateur. Cette opération d'appairage est indispensable pour régler précisément la fréquence d'un oscillateur mécanique.

Très avantageusement, plusieurs centaines de spiraux peuvent être fabriqués sur une seule plaquette (en anglais « wafer ») en utilisant les technologies de microfabrication. Il est notamment connu de réaliser une pluralité de résonateurs en silicium avec une très haute précision en utilisant des procédés de photolithographie et d'usinage / gravure dans une plaquette en silicium. Les procédés de réalisation de ces résonateurs mécaniques utilisent généralement des plaquettes de silicium monocristallin, mais des plaquettes en d'autres matériaux sont également utilisables, par exemple en silicium polycristallin ou amorphe, en d'autres matériaux semiconducteur, en verre, en céramique, en carbone ou en un composite comprenant ces matériaux. Pour sa part, le silicium monocristallin est relativement insensible aux champs magnétiques et appartient à la classe cristalline cubique m3m dont le coefficient d'expansion thermique (alpha) est isotrope.

Le silicium présente une valeur du premier coefficient thermoélastique très négative, et par conséquent, la raideur d'un résonateur en silicium, et donc sa fréquence propre, varie fortement selon la température. Afin de compenser au moins partiellement cet inconvénient, les documents EP1422436, EP2215531 et WO2016128694 décrivent un résonateur mécanique de type spiral réalisé à partir d'une âme (ou d'une bi-âme dans le cas de WO2016128694) en silicium monocristallin et dont les variations en température du module d'Young sont compensées par une couche en oxyde de silicium ($SiO_2$) amorphe entourant l'âme (ou les âmes), ce dernier étant un des rares matériaux présentant un coefficient thermoélastique positif.

Lorsque l'on réalise des spiraux en silicium ou en un autre matériau par fabrication collective sur une plaquette, le rendement fonctionnel final sera donné par le nombre de spiraux dont la raideur correspond à l'intervalle d'appairage, divisé par le nombre total de spiraux sur la plaquette.

Cependant, les étapes de microfabrication et plus particulièrement de gravure employées dans la fabrication de spiraux sur une plaquette résultent typiquement en une dispersion géométrique importante entre les dimensions des spiraux d'une même plaquette, et donc d'une dispersion importante entre leurs raideurs, nonobstant que le motif de gravure est le même pour chaque spiral. La dispersion de raideur mesurée suit normalement une distribution gaussienne, et afin d'optimiser le rendement de fabrication, on s'intéresse donc à centrer la moyenne de la distribution gaussienne sur une valeur de raideur nominale et également à réduire l'écart-type de cette gaussienne.

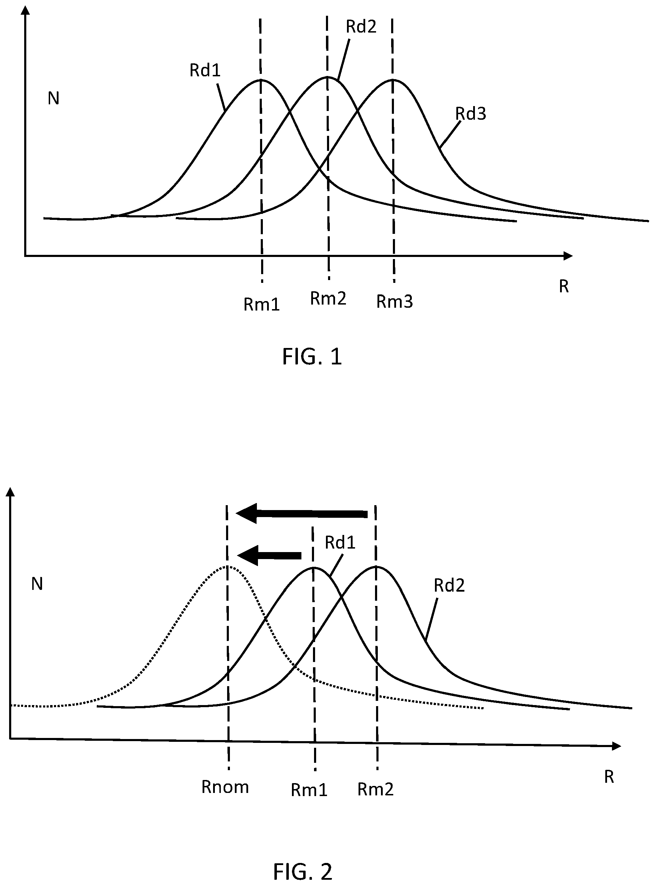

De plus, la dispersion de raideurs est encore plus grande entre des spiraux de deux plaquettes gravées à des moments différents suivant les mêmes spécifications de procédé. Ce phénomène est montré à la figure 1 où les courbes de dispersion de la raideur Rd1, Rd2 et Rd3 pour les spiraux sur trois plaquettes différentes sont illustrées. De manière générale, pour chaque plaquette la distribution des raideurs R (par rapport au nombre de spiraux N avec cette raideur) suit la loi normale ou gaussienne, chaque courbe de dispersion étant centrée sur sa valeur moyenne respective Rm1, Rm2 et Rm3.

Les documents WO2015113973 et EP3181938 proposent de remédier ce problème en formant un spiral selon des dimensions supérieures aux dimensions nécessaires pour l'obtention d'un spiral d'une raideur prédéterminée, en mesurant la raideur de ce spiral formé, en calculant l'épaisseur de matériau à retirer pour obtenir les dimensions nécessaires pour l'obtention du spiral avec la raideur prédéterminée, et en retirant cette épaisseur du spiral. De manière similaire, le document EP3181939 propose de remédier ce même problème en formant un spiral selon des dimensions inférieures aux dimensions nécessaires pour l'obtention d'un spiral d'une raideur prédéterminée, en déterminant la raideur de ce spiral formé, en calculant l'épaisseur de matériau à ajouter pour obtenir les dimensions nécessaires pour l'obtention du spiral avec la raideur prédéterminée, et en ajoutant cette épaisseur de matériau au spiral.

De cette manière, comme démontre la figure 2, nonobstant la raideur moyenne Rm1, Rm2, etc. des raideurs sur une plaquette donnée, la courbe de dispersion de raideurs Rd1, Rd2, etc. peut-être recentrée par rapport à une valeur de raideur nominale Rnom.

Ces étapes d'ajustement de la raideur après la gravure des résonateurs sont appliquées universellement à tous les résonateurs sur une plaquette. Pour cette raison, un tel ajustement des raideurs ne réduit pas la dispersion importante de raideurs à travers une plaquette donnée, c'est-à-dire il ne réduit pas l'écart-type de la distribution qui reste toujours important. Pour cette raison, le rendement fonctionnel pour l'ensemble de spiraux sur chaque plaquette reste relativement faible.

D'autres antériorités sont dévoilées par les documents EP 2 565 727, WO2019/166922, EP 3 285 124, JP 2017/044533, EP 2 753 984, EP 3 769 160 et EP 3 769 161, ces dernières deux références représentant de l'art antérieur selon l'Art. 54(3) CBE.

Bref résumé de l'invention

Un but de la présente invention est de proposer un procédé de fabrication d'une pluralité de résonateurs mécaniques sur une plaquette, notamment pour l'organe régulateur d'un mouvement d'horlogerie mécanique, qui permet d'éviter ou pallier les inconvénients ci-dessus, ou en tout cas d'offrir un meilleur compromis entre ces inconvénients.

En particulier, un but de la présente invention est de proposer un nouveau procédé de fabrication permettant de corriger la dispersion des raideurs d'une plaquette de résonateurs afin de s'assurer qu'une plus grande partie de la distribution gaussienne des raideurs se superpose à un intervalle d'appairage prédéfini. Selon l'invention, la réduction de l'écart-type dans la dispersion des raideurs des résonateurs sur la plaquette est réalisée en modifiant l'étape de lithographie pour différents champs sur la plaquette avant l'usinage des résonateurs.

Selon un aspect, ces buts sont atteints au moyen d'un procédé de fabrication d'une pluralité de résonateurs mécaniques dans une plaquette, les résonateurs étant destinés à équiper un organe régulateur d'une pièce d'horlogerie et la fabrication comprenant au moins une étape de lithographie pour former des motifs des résonateurs sur ou au-dessus ladite plaquette et une étape d'usinage dans ladite plaquette à travers desdits motifs, le procédé comprenant les étapes suivantes : établir une cartographie indicative de la dispersion de raideurs par rapport à une valeur de raideur moyenne pour des résonateurs fabriqués selon des spécifications de référence ; diviser la cartographie en des champs et déterminer une correction à implémenter aux dimensions des résonateurs pour au moins un desdits champs afin de réduire ladite dispersion ; modifier les spécifications de référence pour l'étape de lithographie afin d'implémenter les corrections aux dimensions pour ledit au moins un champ lors de l'étape de lithographie ; et fabriquer des résonateurs sur une plaquette de fabrication en utilisant les spécifications modifiées.

Selon un autre aspect, ces buts sont atteints au moyen d'un procédé de fabrication d'une pluralité de résonateurs mécaniques (100) dans une plaquette de fabrication (10), les résonateurs étant destinés à équiper un organe régulateur d'une pièce d'horlogerie. Le procédé comprend les étapes suivantes : (a) fabriquer une pluralité de résonateurs dans au moins une plaquette de référence en suivant des spécifications de référence, cette fabrication comprenant au moins une étape de lithographie pour former des motifs des résonateurs sur ou au-dessus ladite plaquette de référence et une étape d'usinage dans ladite plaquette de référence à travers desdits motifs ; (b) pour l'au moins une plaquette de référence, établir une cartographie indicative de la dispersion de raideurs des résonateurs par rapport à une valeur de raideur moyenne; (c) diviser la cartographie en des champs et déterminer une correction à implémenter aux dimensions des résonateurs pour au moins un desdits champs afin de réduire ladite dispersion ; (d) modifier les spécifications de référence pour l'étape de lithographie afin d'implémenter les corrections aux dimensions pour ledit au moins un champ lors de l'étape de lithographie ;
(e) fabriquer des résonateurs sur une plaquette de fabrication en utilisant les spécifications modifiées.

D'autres caractéristiques avantageuses et privilégiées de ce procédé de fabrication sont précisées dans la description et les sous-revendications ci-dessous.

Avantageusement, l'approche de la présente invention impliquant des ajustements à l'étape de lithographie pour le réglage dimensionnel de résonateurs mécaniques sur une plaquette sert à améliorer les rendements fonctionnels (de raideur) sur des plaquettes de fabrication d'une manière très importante par rapport à des plaquettes de référence, tout en s'affranchissant de l'étude approfondie et de l'optimisation de chaque étape de la fabrication.

Brève description des figures

Des exemples de mise en œuvre de l'invention sont indiqués dans la description illustrée par les figures annexées dans lesquelles:

- La figure 1 montre les courbes de dispersion de raideurs non corrigées pour les spiraux sur trois plaquettes différentes.

- La figure 2 montre le centrage de la moyenne des raideurs sur une plaquette autour d'une valeur nominale.

- Les figures 3A-3G sont une représentation simplifiée d'un procédé de fabrication d'un résonateur mécanique, ici un spiral, sur une plaquette.

- La figure 4 montre une comparaison d'une distribution de raideurs des résonateurs sur une plaquette de l'état de la technique avec une distribution de raideurs avec une correction de la dispersion selon l'invention.

- La figure 5 illustre une plaquette comprenant une pluralité de spiraux partiellement divisés en champs.

- La figure 6 illustre une cartographie de la dispersion des raideurs par champ sur une plaquette.

- La figure 7 est un diagramme montrant les étapes principales d'un procédé de fabrication d'une pluralité de résonateurs selon un mode de réalisation privilégié de l'invention.

- La figure 8 montre la correction de la dispersion de raideurs sur une plaquette avec un centrage autour d'une valeur nominale de la raideur selon l'invention.

- La figure 9 illustre un système de stepper-réticule pour l'étape de la lithographie selon un mode de réalisation.

Exemple(s) de mode de réalisation de l'invention

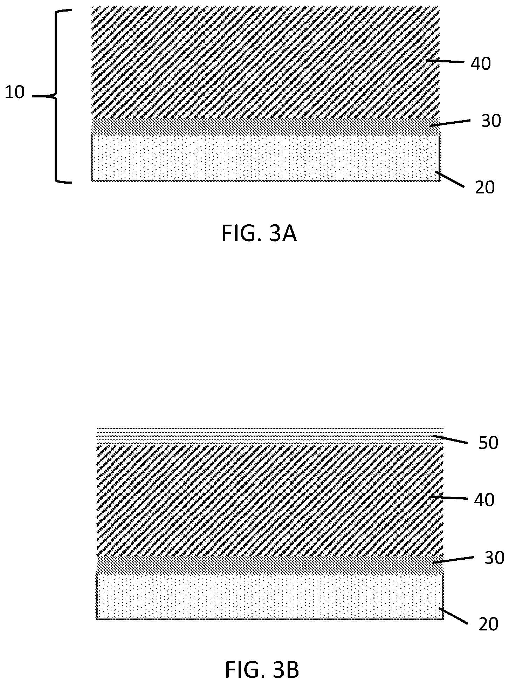

Les figures 3A-3G sont une représentation simplifiée d'un procédé de fabrication d'un résonateur mécanique 100 sur une plaquette 10. Le résonateur est notamment destiné à équiper un organe régulateur d'une pièce d'horlogerie et, selon cet exemple, est en forme d'un ressort spiral 100 en silicium qui est destiné à équiper un balancier d'un mouvement d'horlogerie mécanique.

La plaquette 10 est illustrée à la figure 3A en tant que wafer SOI (« silicon on insulator ») et comprend un substrat ou « handler » 20 portant une couche d'oxyde de silicium ($SiO_2$) sacrificielle 30 et une couche de silicium monocristallin 40. A titre d'exemple, le substrat 20 peut avoir une épaisseur de 500 $\mu$m, la couche sacrificielle 30 peut avoir une épaisseur de 2 $\mu$m et la couche en silicium 40 peut avoir une épaisseur de 120 $\mu$m. La couche de silicium monocristallin 40 peut avoir une orientation cristalline quelconque.

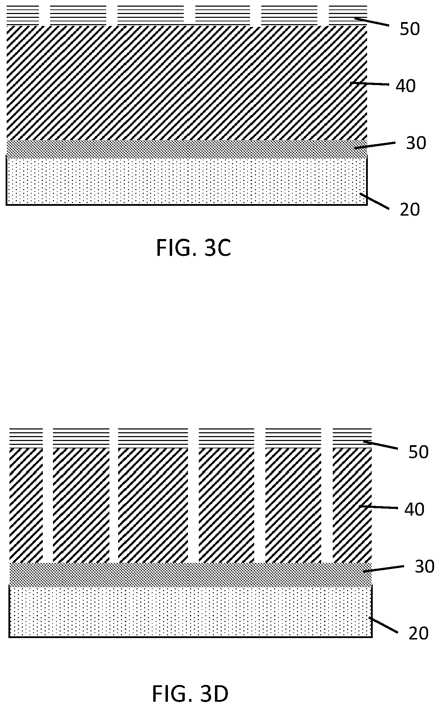

Une étape de lithographie est montrée aux figures 3B et 3C. Par « lithographie », on entend l'ensemble des opérations permettant de transférer une image ou motif sur ou au-dessus de la plaquette 10 vers cette dernière. En se référant à la figure 3B, dans ce mode de réalisation exemplaire, la couche 40 est recouverte d'une couche de protection 50, par exemple en une résine polymérisable. Cette couche 50 est structurée, typiquement par une étape de photolithographie utilisant une source de lumière ultraviolette ainsi que, par exemple, un photomasque (ou un autre type de masque d'exposition) ou un système de stepper et réticule. Cette structuration par lithographie forme les motifs pour la pluralité de résonateurs dans la couche 50, comme illustrée à la figure 3C.

Par la suite, dans l'étape de la figure 3D, les motifs sont usinés, notamment gravés, pour former la pluralité de résonateurs 100 dans la couche 40. La gravure peut être effectuée par une technique de gravure ionique réactive profonde (également connue sous l'acronyme DRIE pour « Deep Reactive Ion Etching »). Après la gravure, la partie restante de la couche de protection 50 est subséquemment éliminée.

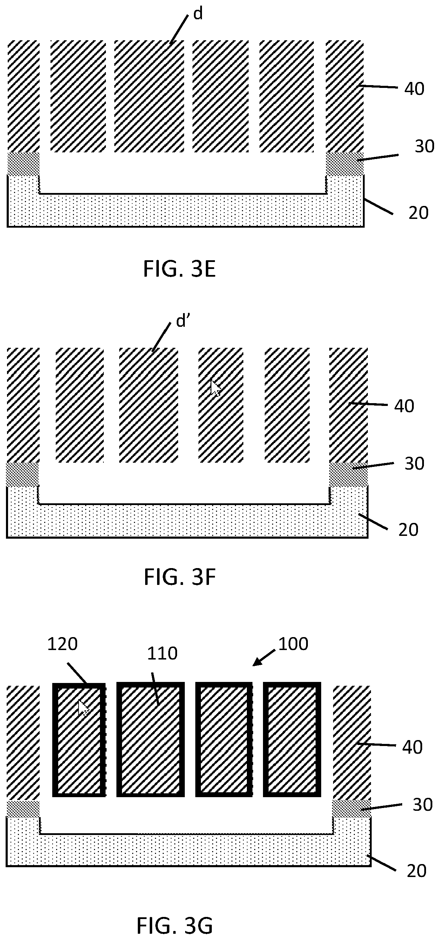

A la figure 3E, les résonateurs sont libérés du substrat 20 en retirant localement la couche oxyde 30 voire en gravant tout ou partie du silicium du substrat ou handler 20. Un lissage (non illustré) des surfaces gravées peut également avoir lieu avant l'étape de libération, par exemple par une étape d'oxydation thermique suivie par une étape de désoxydation, constituée par exemple de la gravure par voie humide à base d'acide fluorhydrique (HF).

Comme indiqué ci-dessus, à ce stade, les différents résonateurs formés dans la plaquette présentent généralement une dispersion géométrique importante entre eux et donc une dispersion importante entre leurs raideurs, nonobstant que les étapes de formation des motifs et de l'usinage/gravure à travers ces motifs sont les mêmes pour tous les résonateurs.

Par ailleurs, cette dispersion de raideurs est encore plus importante entre les spiraux de deux plaquettes gravées à des moments différents nonobstant que les mêmes spécifications de procédé sont utilisées. Pour centrer la moyenne de raideurs des résonateurs sur différentes plaquettes par rapport à une valeur de raideur nominale comme illustré à la figure 2, les résonateurs obtenus à l'étape 3E sur la plaquette 10 en question peuvent être délibérément formés avec des dimensions d qui sont supérieures aux dimensions nécessaires pour l'obtention d'une raideur nominale ou cible. En mesurant les raideurs d'un échantillon de résonateurs sur la plaquette à l'étape 3E, l'épaisseur de matériau à retirer, par exemple autour de chaque spire dans le cadre de spiraux, pour obtenir les dimensions correspondant à la raideur cible peut être calculée. L'étape de mesurer les raideurs peut être effectuée en suivant différentes méthodes bien connues par exemple, dans le cadre d'un spiral, les méthodes décrites dans M. Vermot et al, Traité de construction horlogère (2011) aux pages 178-179 et dans le document EP2423764.

Par la suite, en procédant à une étape d'oxydation thermique suivie par une étape de désoxydation permettant un retrait fin et précis de la quantité de matériau qui est retirée, les dimensions des résonateurs peuvent être finement ajustées pour arriver à des résonateurs de dimensions d', comme illustré à la figure 3F. Plus particulièrement, selon cette approche, la différence dimensionnelle est convertie à une valeur d'épaisseur d'oxyde à faire croître sachant qu'environ 44 % de la couche d'oxyde sera en dessous de la surface d'origine et 56 % au-dessus. Puisque la croissance de la couche oxyde thermique peut être contrôlée précisément, la dimension des spires après la désoxydation de la couche d'ajustement est en théorie très proche de la valeur ciblée.

A la dernière étape du procédé de fabrication à la figure 3G, les spires 110 du résonateur 100 en silicium sont recouvertes d'une couche 120 d'oxyde de silicium (SiO2), typiquement par une étape d'oxydation thermique pour produire un résonateur thermocompensé. La formation de cette couche 120, qui a généralement une épaisseur de 2-5 $\mu$m, affecte également la raideur finale du résonateur et donc doit être prise en compte lors des étapes précédentes.

On a vu ci-dessus, qu'il est connu de centrer la moyenne de la gaussienne des raideurs sur la valeur nominale spécifiée, mais que cela ne réduit pas l'écart-type important de cette distribution. En revanche, la présente invention sert à réduire l'écart-type dans la dispersion des raideurs d'une plaquette de résonateurs afin de s'assurer que la plus grande partie de la gaussienne se superpose à l'intervalle d'appairage.

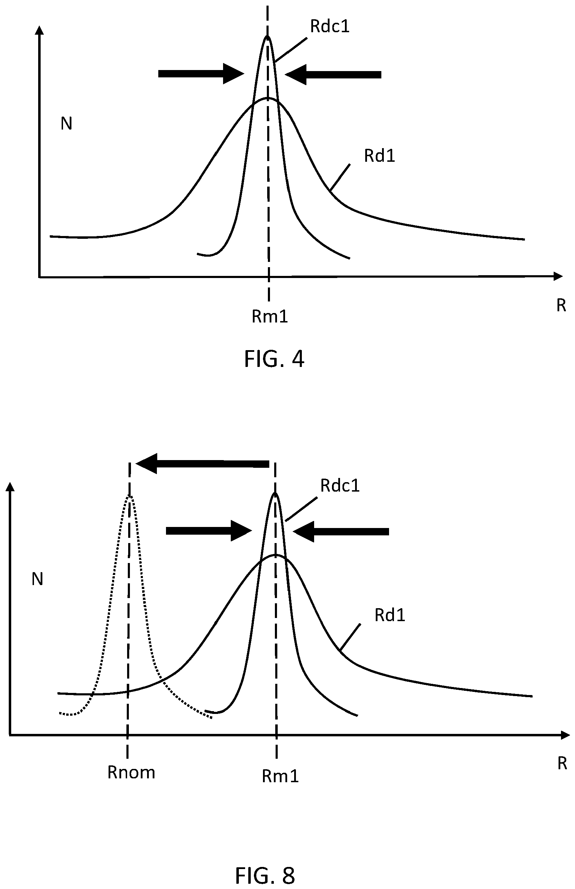

Selon l'invention, la réduction de l'écart-type dans la dispersion des raideurs des résonateurs sur la plaquette est réalisée en modifiant, localement sur plaquette, l'étape de lithographie avant l'usinage des résonateurs. Le principe du résultat de cette réduction est montré à la figure 4, en comparant une distribution de raideurs Rd1 des résonateurs sur une plaquette de l'état de la technique avec une distribution de raideurs Rdc1 avec une correction de la dispersion de raideurs selon la présente invention.

De manière générale, un procédé de la fabrication d'une pluralité de résonateurs comprend une série de technologies de microfabrication choisie en fonction de la composition des résonateurs, de l'application prévue de ces derniers ainsi que d'autres aspects tels que le coût de fabrication. Le procédé est alors caractérisé par plusieurs facteurs et éléments techniques qui influencent la géométrie des résonateurs incluant, à titre d'exemple : le choix de matériaux des couches et films employés et leurs épaisseurs, les compositions chimiques du ou des éléments d'attaques pour la gravure, la durée des opérations, le choix d'équipement de microfabrication, la technologie employée pour obtenir le masque de gravure, etc. Pour un procédé de fabrication donné, on appelle ici ces facteurs et éléments techniques les « spécifications de référence. »

Les inventeurs ont constaté que deux étapes fondamentales déterminent la précision et la répétabilité d'un procédé de fabrication de résonateurs sur une plaquette : la formation des motifs des résonateurs sur la plaquette et l'usinage des résonateurs à travers ces motifs dans la plaquette. C'est alors surtout les spécifications de référence de ces étapes qui déterminent la forme de la dispersion des raideurs sur la plaquette telle qu'illustrée à la figure 1. On appelle ici cette forme de la dispersion des raideurs, la « signature de dispersion » du procédé, car elle est répétable et n'est pas aléatoire pour un procédé de fabrication de résonateurs donné, cette signature représentant l'effet superposé de la succession de toutes les étapes de fabrication. Autrement dit, si plusieurs plaquettes de résonateurs sont produites selon les mêmes spécifications de référence, leurs signatures restent généralement constantes même si la moyenne de raideurs peut varier et évoluer dans le temps d'une manière importante d'une plaquette à l'autre.

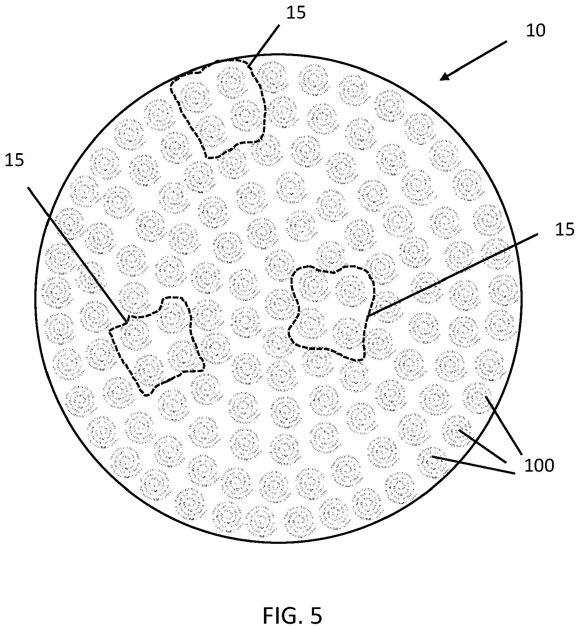

Dans le cas d'un procédé de fabrication d'une plaquette 10 comprenant une pluralité de spiraux en silicium 100 comme illustré à la figure 5, les étapes en question sont typiquement la lithographie qui comprend l'ensemble des opérations permettant de transférer la géométrie exacte du spiral vers la plaquette et la gravure profonde permettant d'usiner les spiraux dans leur forme finale. Plus particulièrement, la dispersion des raideurs qu'on observe à la fin d'un procédé de fabrication de ces spiraux selon l'état de la technique est due, en grande partie, à la forme de la chambre de réaction DRIE et à la distribution du nuage de plasma dans cette chambre. Cette signature de dispersion due à l'étape de la gravure profonde de la plaquette est très répétable, pas seulement en ce qui concerne sa distribution gaussienne, mais également en ce qui concerne la cartographie de la dispersion des raideurs sur la plaquette.

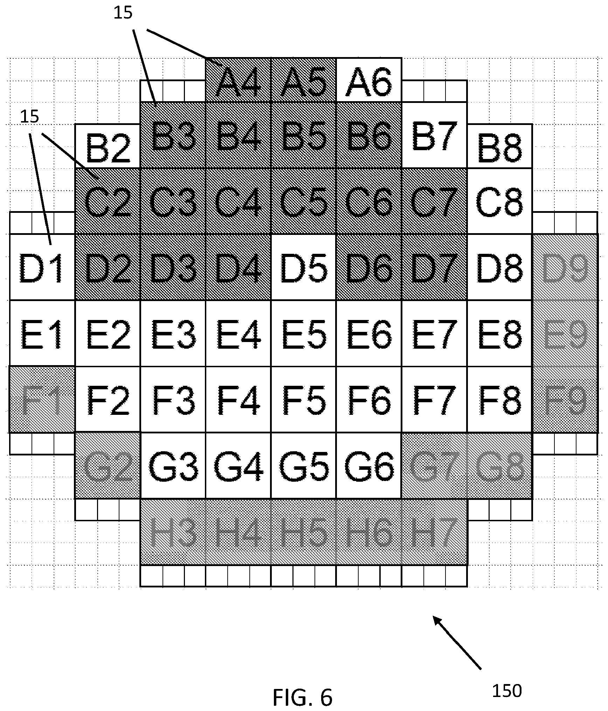

Un exemple d'une telle cartographie 150 de la dispersion des raideurs sur une plaquette est illustré à la figure 6 en groupant les résonateurs localement dans des champs (ou zones) 15 sur la plaquette. Chaque champ comprend au moins un résonateur, et de préférence chaque champ comprend de 2-20 résonateurs et plus préférentiellement de 5-15 résonateurs. Les raideurs de différents résonateurs dans un champ sont proches l'une de l'autre, car ces derniers se trouvent dans le même voisinage de la plaquette. Quelques champs 15 sont illustrés sur la plaquette de la figure 5, et dans la figure 6 la plaquette est symboliquement divisée en une matrice de 56 champs.

Dans la cartographie 150 de la figure 6, les champs D9, E9, F1, F9, G2, G7, G8, H3, H4, H5, H6, H7 comprennent des résonateurs avec des raideurs relativement élevées, et les champs A4, A5, B3, B4, B5, B6, C2, C3, C4, C5, C6, C7, D2, D3, D4, D6, D7 comprennent des résonateurs avec des raideurs relativement réduites par rapport au reste des champs de la plaquette (notamment vers son centre) qui comprennent des résonateurs avec des raideurs plus près de la moyenne de la distribution. Cette cartographie de la dispersion des raideurs sur une plaquette reste très similaire pour chaque plaquette produite selon les mêmes spécifications de référence, bien que la moyenne de raideurs des résonateurs puisse varier d'une plaquette à l'autre.

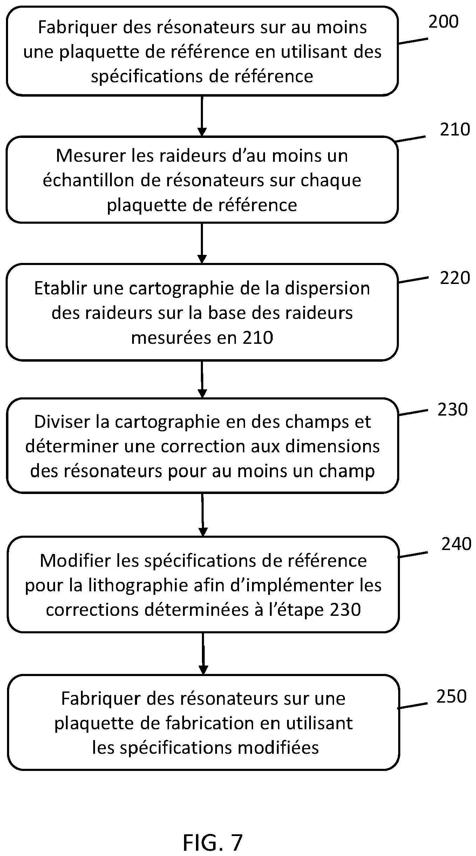

La figure 7 est un diagramme des étapes principales d'un procédé de fabrication d'une pluralité de résonateurs sur une plaquette de fabrication selon un mode de réalisation privilégié de la présente invention. Dans une première étape 200, sur au moins une plaquette de référence, on fabrique la pluralité de résonateurs sur la plaquette en suivant des spécifications de référence pour le procédé. Cette étape 200 comprend notamment la formation des motifs des résonateurs (la lithographie) et l'usinage à travers de ces motifs d'exposition. Cette étape 200 peut être effectuée pour plusieurs plaquettes de référence, de préférence entre 10 à 30 plaquettes afin d'établir un référentiel statistique suffisamment fiable. De préférence, les spécifications de référence pour le procédé sont les mêmes pour chaque plaquette de référence, mais selon une variante des spécifications de référence différentes peuvent être utilisées pour au moins certaines des plaquettes de référence.

A l'étape suivante 210, on mesure les raideurs des résonateurs sur chaque plaquette de référence. De préférence, on mesure les raideurs d'un échantillon de résonateurs, de préférence d'au moins 5% ou plus préférentiellement d'au moins 10% des résonateurs sur chaque plaquette de référence. Alternativement, au moins un résonateur est mesuré pour chacun des champs qui seront définis à l'étape 230 ci-dessous. Si nécessaire, on peut aussi mesurer l'ensemble des résonateurs de la plaquette de référence.

La mesure de la raideur peut être en utilisant une méthode de mesure quelconque (incluant des mesures mécaniques/physiques comme optiques/dimensionnelles) connue par l'homme du métier. Puisque la raideur d'un résonateur est dépendante de son dimensionnel, il est également possible de mesurer les dimensions des résonateurs, par exemple par tomographie, par une mesure optique, ou autrement.

Par la suite, à l'étape 220, une cartographie commune de la dispersion des raideurs par rapport à une valeur de raideur moyenne est établie sur la base des raideurs mesurées pour l'ensemble des plaquettes de référence. De préférence, cette valeur de raideur moyenne est la moyenne des raideurs mesurées au centre de chaque plaquette de référence.

Dans un mode de réalisation alternatif, à la place des étapes 200, 210 et 220, un outil de simulation numérique capable de simuler la fabrication des résonateurs dans une plaquette en suivant les spécifications de références peut être employé pour établir une cartographie virtuelle de la dispersion des raideurs sur la plaquette. Une telle cartographie virtuelle serait typiquement moins précise qu'une cartographie obtenue en suivant les étapes 200, 210 et 220 mais elle pourrait être utilisée par exemple pour un premier cycle des corrections dans un procédé de fabrication évolutif, comme l'est décrit ci-dessous.

En se référant toujours à la figure 7, à l'étape 230 on divise la cartographie de la plaquette en des champs et on détermine une correction à implémenter aux dimensions des résonateurs pour au moins un de ces champs. Les champs peuvent contenir un même nombre de résonateurs ou un nombre différent, selon la dispersion localement et la taille des lots pour atteindre la répétabilité désirée. Dans un exemple, au moins la majorité de champs comprend le même nombre de résonateurs. Dans le cadre de spiraux, on peut par exemple calculer une épaisseur de spire effective pour chaque champ (groupe) de spiraux. Dans ce cas, l'épaisseur de spire effective correspond à la moyenne des épaisseurs effectives pour les spiraux dans le champ. Par la suite, on peut par exemple déterminer la quantité à ajouter ou à enlever par rapport à une valeur d'épaisseur (e) de spire nominale, correspondant à la raideur nominale. Dans un mode de réalisation, on peut tout simplement se référer à la formule pour la raideur évoquée ci-dessus et calculer analytiquement l'épaisseur effective en considérant les autres paramètres constants. Selon des variantes, d'autres méthodes de calcul plus complexes peuvent être utilisées, par exemple une méthode par éléments finis.

En reprenant l'exemple de la cartographie 150 dans la figure 6, la correction aux champs D9, E9, F1, F9, G2, G7, G8, H3, H4, H5, H6, H7 impliquerait une réduction de l'épaisseur effective des résonateurs dans chacun de ces champs, le montant de la réduction pouvant être bien entendu différent parmi ces champs. La correction aux champs A4, A5, B3, B4, B5, B6, C2, C3, C4, C5, C6, C7, D2, D3, D4, D6, D7 impliquerait par contre une augmentation de l'épaisseur effective des résonateurs dans chacun de ces champs. Encore une fois, le montant de l'augmentation peut être différent pour chacun de ces derniers champs. Autrement, pour les résonateurs dans les autres champs de la cartographie 150 de la figure 6 (vers le centre de la cartographie), aucune modification de l'épaisseur effective n'est nécessaire.

A l'étape suivante 240, on modifie les spécifications de référence en ajustant l'étape de la lithographie, c'est-à-dire l'étape de former les motifs des résonateurs, afin d'implémenter les corrections déterminées à l'étape 230 pour chacun des champs nécessitant une correction des dimensions des résonateurs qui s'y trouvent.

Finalement, à l'étape 250 on fabrique la pluralité de résonateurs en utilisant les spécifications modifiées sur au moins une plaquette de fabrication qui est du même type que la ou les plaquette(s) de référence. La dispersion corrigée des raideurs des résonateurs formés sur ces plaquettes de fabrication est alors fortement réduite, comme la montre la figure 4.

L'étape 250 peut bien entendu inclure différentes étapes de fabrication telles que le centrage de la moyenne de la gaussienne des raideurs sur une valeur de raideur nominale spécifiée par un ajustement des dimensions des résonateurs sur la plaquette (figure 3F) et la formation d'une couche de thermocompensation (figure 3G). (Bien entendu, de telles étapes peuvent également être réalisées lors de la fabrication des résonateurs sur une plaquette de référence, mais en obtenant un rendement fonctionnel inférieur.) Le principe du centrage de la moyenne de la gaussienne des raideurs est montré à la figure 8 où la dispersion dans la distribution des raideurs est initialement réduite selon les étapes 240 et 250 ci-dessus pour passer d'une distribution Rd1 à une distribution corrigée Rdc1, et par la suite cette distribution corrigée Rdc1 est centrée sur la raideur nominale Rnom.

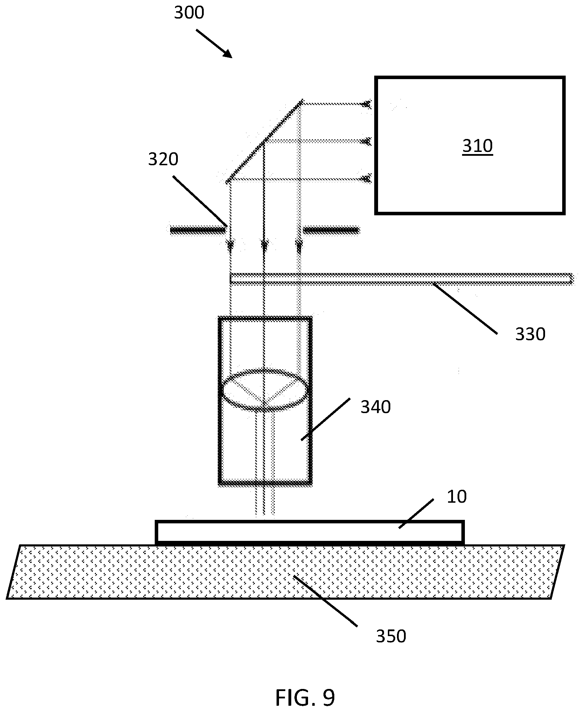

Toutefois, dans certains modes de réalisation tel que le mode décrit ci-dessous en conjonction avec la figure 9, l'ajustement de la lithographie à l'étape 240 peut permettre non seulement de réduire la dispersion, mais également de centrer ou déplacer la distribution des raideurs des résonateurs sur la plaquette de fabrication sur ou vers la raideur nominale Rnom. Cela permet d'éviter, ou du moins de faciliter ou de soutenir, une étape de centrage ultérieur à l'instar de celle décrite en conjonction avec la figure 3F.

Selon un mode de réalisation, une plaquette de fabrication qui a subi des corrections peut également devenir une « plaquette de référence corrigée » pour un nouveau cycle des étapes du procédé selon l'invention à la figure 7, la plaquette de référence corrigée jouant ainsi le rôle d'une plaquette de référence. De cette manière, le procédé de fabrication selon l'invention devient évolutif et peut être mis à jour à chaque lot de plaquettes fabriqué afin de constituer une référence historique de l'évolution du procédé. Cela permet également de visualiser et suivre la distribution de raideur par champs de la plaquette avec le temps.

De manière générale, l'ajustement de la lithographie à l'étape 240 afin d'implémenter les corrections sur la cartographie des raideurs des plaquettes de référence peut être réalisé par différentes manières en fonction des techniques de microfabrication et des spécifications de référence qui sont employées. Ces dernières peuvent largement varier en fonction de plusieurs facteurs incluant notamment le matériau (ou les matériaux) des résonateurs.

La lithographie utilise typiquement un « masque d'usinage » (par exemple la couche de protection structurée 50 dans la figure 3C) qui est une couche ajourée présente sur la face de la plaquette et qui est exposée lors de l'opération d'usinage/gravure. Certaines technologies de lithographie utilisent également un « masque d'exposition » qui est un masque employé pour assurer l'exposition puis l'ajourage de la couche de protection du substrat lors de l'opération d'usinage.

Pour des résonateurs (et donc des plaquettes) en silicium, le masque d'usinage peut être par exemple structuré selon l'une des méthodes suivantes : lithographie par electron-beam (e-beam) qui est typiquement reconnu comme étant « maskless » ; la photolithographie avec un masque d'exposition qui est en principe unique, fixe et non programmable ; la photolithographie sans un tel masque d'exposition, par exemple avec un système de stepper et réticule à la place ; la photolithographie avec un masque reprogrammable, par exemple avec des verres activables électriquement pour l'exposition ; et la photolithographie pas écriture laser (ou équivalent) directe, par exemple sur une résine photosensible.

La correction de la dispersion des raideurs peut avoir lieu avant l'étape de lithographie, par exemple en corrigeant les dimensions des résonateurs répartis sur un masque d'exposition ou en corrigeant les dimensions d'un masque programmable.

La correction de la dispersion des raideurs peut alternativement avoir lieu pendant l'étape de lithographie, par exemple en corrigeant la dose de l'insolation, en corrigeant la distance entre le masque d'exposition et le masque d'usinage, d'un champ de la plaquette à l'autre (effet de « shadow masking »), ou en faisant appel à une illumination télécentrique, si la dispersion résulte d'une erreur de télécentricité.

Encore dans une autre variante, on peut faire appel à un système comprenant un filtre d'illumination et un masque d'exposition en tant que photomasque. Selon cette variante, on expose le masque d'usinage en plusieurs zones, le photomasque ayant une ouverture restreinte qui permet de sélectionner laquelle des géométries du filtre d'illumination sera employée. Ainsi, le filtre d'illumination peut comporter le profil d'un composant aux dimensions cibles et au moins un profil aux dimensions corrigées, le choix du profil à aligner avec l'ouverture du photomasque dépendant du champ de la cartographie (déplacement du système complet sur la plaquette, ainsi que déplacement du filtre d'illumination par rapport au photomasque). Un tel système comprenant un filtre d'illumination est décrit par exemple par Voelkel et al., Advanced mask aligner lithography : new illumination system, Optic Express Vol. 18, No. 20, Septembre 2010. Selon une autre approche similaire, on peut employer un procédé de lithographie par interférence laser au moyen d'un réseau de diffraction et varier ce dernier en fonction de la cartographie des raideurs sur la plaquette.

La correction de la dispersion des raideurs peut également avoir lieu après une première étape de lithographie, notamment en corrigeant le masque d'usinage ou de gravure durant (ce qu'on appelle ici) une deuxième étape de lithographie. Plus particulièrement, pour des plaquettes réalisées en céramique ou en certains autres matériaux non semiconducteurs, le masque d'usinage pourra être réalisé à partir d'une couche de matériau dur (par opposition à une couche de résine photosensible), comme par exemple un métal ou un alliage métallique, qui serait ensuite structuré par attaque chimique après avoir préalablement déposé un premier masque (ex. par photolithographie d'une résine photosensible). Un exemple de cette approche pour un masque d'usinage métallique est décrit dans Scanning Probe Lithography, de Singh et al., Techniques used for maskless lithography, Int. Journal of Science and Research India Vol. 2, Issue 7, Juillet 2013. Les dimensions du masque d'usinage métallique pourront être corrigées par une croissance métallique localisée (galvanoplastie), en alimentant seulement les pistes des zones qui doivent être corrigées. De manière préférentielle, les dimensions obtenues lors de l'étape de lithographie précédente seront inférieures aux dimensions cibles, de sorte qu'elles puissent être corrigées par l'accroissement de la zone de masquage obtenu par cette étape de correction.

Selon un mode de réalisation privilégié de la présente invention, l'étape de lithographie du procédé de fabrication est réalisée avec un système de stepper et réticule 300 tel qu'illustré dans la figure 9. Ce système 300 comprend une source d'insolation (voire de radiation) 310 (typiquement de la lumière UV) qui, par le biais d'une ouverture d'exposition 320, un réticule 330 et un dispositif de lentilles optiques 340, insole des champs de la plaquette (voire de la couche de protection 50 sur la plaquette) successivement par pas. La plaquette 10 est montée sur un support 350 amovible qui de manière connue est précisément positionné par un système de contrôle de pas afin qu'uniquement un champ de la plaquette soit insolé à la fois. Le fonctionnement du stepper 300 est similaire à celui d'un projecteur de diapositives, et le terme « stepper » est une abréviation de step-and-repeat caméra. Le système 300 permet l'utilisation d'un petit réticule 330 à la place d'un masque d'exposition large fixe. La dose d'insolation peut donc être adaptée localement en fonction de la position relative du stepper/réticule au-dessus de la plaquette de manière à obtenir, dans la couche de protection 50, des motifs plus ou moins larges.

De manière générale, l'utilisation d'un système de stepper et réticule pour l'étape de lithographie du procédé de fabrication présente plusieurs avantages. Par exemple, elle ne nécessite pas de fabriquer régulièrement des nouveaux masques (par exemple des masques de photolithographie utilisés en contact ou en proximité de la résine photosensible), ce qui représente un surcoût de fabrication et nécessite un temps plus long pour assurer l'ajustement. Avec un système de stepper, on conserve le réticule de lithographie (pas de surcoût) et on peut travailler en ligne directement. De plus, la lithographie de contact ou de proximité présente une résolution de lithographie bien inférieure à la résolution de la lithographie stepper, voire une dimension critique (« Critical Dimension » ou CD) de 1.5 à 2 $\mu$m en lithographie de contact ou de proximité contre un CD de 0.35 $\mu$m ou plus fin encore pour un stepper. Par ailleurs, la productivité d'un équipement stepper est plus importante que celle pour la lithographie de contact ou de proximité.

L'utilisation d'un système de stepper et réticule selon ce mode de réalisation de la présente invention est aussi avantageuse puisqu'elle permet d'augmenter le rendement d'une part, par la correction de la dose nominale en ligne ce qui sert à contrôler la variation de la raideur moyenne de la plaquette par rapport à une valeur de raideur nominale, et d'autre part, par la réduction de l'écart-type dans la dispersion des raideurs en compensant la dose de lithographie par champs.

En particulier, pour ce mode de réalisation en utilisant un stepper, on peut caractériser préalablement la relation entre le dimensionnel obtenu à l'étape de lithographie et la dose appliquée, c'est-à-dire la courbe CD vs dose, CD étant la dimension critique (« Critical Dimension ») du système 300. D'une manière générale, en négligeant les effets de bord de la plaquette et en considérant une plage de variation de dose inférieure à 100 mJ, le dimensionnel obtenu est proportionnel à la dose utilisée pour la lithographie. La relation CD vs dose est alors décrite par une droite sous la forme :

$$CD = m \cdot dose + cd0$$

On constate que, pour une résine (couche de protection 50) donnée, le coefficient de proportionnalité m est constant dans le temps, alors que le biais dimensionnel *cd0* peut varier.

Afin de toujours cibler la bonne valeur de CD, il faut donc déterminer le coefficient cd0 pour la ou les plaquettes de référence puis recalculer la dose à utiliser pour les plaquettes de fabrication. Plus particulièrement, pour chaque plaquette de référence, la lithographie est effectuée avec une dose de test d1. La moyenne du dimensionnel cd1 mesuré au centre de chaque plaquette de référence permet de déterminer la valeur de cd0 d'une plaquette de fabrication. La dose à utiliser sur une plaquette de fabrication est ensuite calculée comme suit :

$$dose = d1 + \frac{cible - cd1}{m}$$

La dose ainsi calculée est finalement utilisée comme dose nominale pour la réalisation de l'étape de lithographie sur les plaquettes de fabrication. Cet ajustement permet avantageusement de placer le centre de la gaussienne des raideurs dans la proximité de la valeur ciblée pour la raideur nominale.

Ensuite selon ce mode de réalisation avec stepper, on caractérise la relation entre la raideur des résonateurs usinés et la dose de lithographie. Connaissant la dépendance cubique de la raideur du ressort spiral à l'épaisseur de ses spires, on peut compenser la signature de dispersion sur une plaquette de fabrication, en augmentant le CD pour les champs présentant une raideur insuffisante (par exemple les champs A4, A5, B3, B4, B5, B6, C2, C3, C4, C5, C6, C7, D2, D3, D4, D6, D7 de la cartographie 150 de la figure 6), et en diminuant le CD pour les champs présentant une raideur excessive (par exemple les champs D9, E9, F1, F9, G2, G7, G8, H3, H4, H5, H6, H7 de la cartographie 150 de la figure 6).

Aux fins de la compensation selon cet exemple, on corrige l'écart entre la raideur (et la CD) mesurée dans les champs de la plaquette par rapport au champ situé au centre. On définit alors une valeur de ΔCD pour chaque champ de la plaquette, puis on la traduit en un biais qui sera appliqué à la dose nominale.

Alternativement, selon une variante, on peut choisir arbitrairement les valeurs de biais à appliquer, puis mesurer la nouvelle dispersion des raideurs sur une plaquette de référence corrigée et comparer cette dispersion mesurée à la cartographie établie pour la ou les autres plaquettes de référence. A partir de cette comparaison, on peut calculer une nouvelle fois les biais. Afin de simplifier ce calcul, on peut faire l'hypothèse que pour de très petites variations de l'épaisseur e, la raideur du spiral est directement proportionnelle à l'épaisseur de spire, qui est à son tour proportionnelle à la dose appliquée :

$$M \sim e \sim m \cdot dose$$

Ainsi, après avoir fabriqué une plaquette de référence ajustée où la compensation de l'ajustement a été choisie arbitrairement, la compensation à appliquer sur une plaquette de fabrication peut être déterminée avec une simple règle de proportionnalité. La correction initiale à appliquer sur une plaquette de référence corrigée peut également être calculée en inversant la formule de la raideur afin d'estimer l'épaisseur de spire réellement fabriquée et, à partir de là, le ΔCD à appliquer.

Le procédé de fabrication de la présente invention est applicable à la fabrication de résonateurs mécaniques dans des plaquettes en différents types de matériaux, tels que le silicium polycristallin ou amorphe, un autre matériau semiconducteur, un verre, une céramique, le carbone ou un matériau composite (par exemple un matériau composite comprenant des nanotubes de carbone). Dans ces cas, la couche 40 en silicium monocristallin de la plaquette serait bien entendu remplacée par une couche en le matériau voulu et des techniques de microfabrication appropriées pour ce matériau seraient choisies pour les étapes de lithographie et usinage.

**Revendications**

1.  Un procédé de fabrication d'une pluralité de résonateurs mécaniques (100) dans une plaquette de fabrication (10), les résonateurs étant destinés à équiper un organe régulateur d'une pièce d'horlogerie, le procédé comprenant les étapes suivantes :

    (a) fabriquer une pluralité de résonateurs dans au moins une plaquette de référence en suivant des spécifications de référence, cette fabrication comprenant au moins une étape de lithographie pour former des motifs des résonateurs sur ou au-dessus ladite plaquette de référence et une étape d'usinage dans ladite plaquette de référence à travers desdits motifs ;
    (b) pour l'au moins une plaquette de référence, établir une cartographie indicative de la dispersion de raideurs des résonateurs par rapport à une valeur de raideur moyenne;
    (c) diviser la cartographie en des champs et déterminer une correction à implémenter aux dimensions des résonateurs pour au moins un desdits champs afin de réduire ladite dispersion ;
    (d) modifier les spécifications de référence pour l'étape de lithographie afin d'implémenter les corrections aux dimensions pour ledit au moins un champ lors de l'étape de lithographie ;
    (e) fabriquer des résonateurs sur une plaquette de fabrication en utilisant les spécifications modifiées.

2.  Procédé selon la revendication 1, **caractérisé en ce que** chaque champ comprend au moins un résonateur.

3.  Procédé selon la revendication 2, **caractérisé en ce que** chaque champ comprend une pluralité de résonateurs, de préférence de 2 à 20 résonateurs, et plus préférentiellement de 5-15 résonateurs.

4.  Procédé selon l'une des revendications précédentes, **caractérisé en ce qu'**au moins la majorité de champs comprend le même nombre de résonateurs.

5.  Procédé selon l'une des revendications précédentes, caractérisé en ce l'étape (a) est effectué pour une pluralité de plaquettes de référence, de préférence 10 à 30 plaquettes de référence.

6.  Procédé selon l'une des revendications précédentes, caractérisé en ce l'étape (b) comprend mesurer les raideurs d'un échantillon de résonateurs sur chaque plaquette de référence.

7.  Procédé selon la revendication précédente, **caractérisé en ce que**, pour chaque plaquette de référence, ledit échantillon comprend au moins 5%, de préférence au moins 10%, des résonateurs sur ladite plaquette de référence.

8.  Procédé selon l'une des revendications précédentes, **caractérisé en ce que** la raideur moyenne de la cartographie correspond à la moyenne des raideurs mesurées au centre de chaque plaquette de référence.

9.  Procédé selon l'une des revendications précédentes, **caractérisé en ce que** la modification des spécifications de référence pour l'étape de lithographie à l'étape (d) permet également de déplacer la distribution des raideurs des résonateurs sur la plaquette de fabrication vers une valeur de raideur nominale.

10.  Procédé selon l'une des revendications précédentes, **caractérisé en ce que** le procédé effectue une nouvelle fois les étapes (a)-(e) en prenant au moins une plaquette de fabrication fabriquée à l'étape (e) comme l'au moins une plaquette de référence à la nouvelle étape (a).

11.  Procédé selon l'une des revendications précédentes, **caractérisé en ce que** modifier les spécifications de référence pour l'étape de lithographie à l'étape (d) comprend ajuster une dose d'insolation pour l'au moins un champ.

12.  Procédé selon la revendication précédente, **caractérisé en ce que** l'étape de lithographie pour former les motifs des résonateurs utilise un système de stepper et réticule (300).

13.  Procédé selon la revendication précédente, **caractérisé en ce que** la modification des spécifications de référence pour l'étape de lithographie à l'étape (d) comprend une étape d'ajuster la dose d'insolation nominale en ligne du système de stepper et réticule (300) pour l'au moins un champ, afin de déplacer la distribution des raideurs des résonateurs sur la plaquette de fabrication vers une valeur de raideur nominale.

14.  Procédé selon l'une des revendications 12 et 13, **caractérisé en ce que** modifier les spécifications de référence pour l'étape de lithographie à l'étape (d) comprend ajuster la dimension critique du système de stepper et réticule (300) pour l'au moins un champ.

15.  Procédé selon la revendication précédente, **caractérisé en ce qu'**ajuster la dimension critique du système de stepper et réticule (300) comprend déterminer un biais qui est appliqué à la dose d'insolation nominale pour l'au moins un champ.

16.  Procédé selon l'une des revendications 1 à 10, **caractérisé en ce que** l'étape de lithographie fait appel à un masque programmable, et **en ce que** modifier les spécifications de référence pour l'étape de lithographie à l'étape (d) comprend modifier les dimensions dans le programme commandant le masque programmable pour l'au moins un champ.

17.  Procédé selon l'une des revendications 1 à 10, **caractérisé en ce que** l'étape de lithographie fait appel à un masque comprenant un filtre d'illumination et un masque d'exposition, et **en ce que** modifier les spécifications de référence pour l'étape de lithographie à l'étape (d) comprend choisir et aligner avec le masque d'exposition un profil du résonateur aux dimensions corrigées du filtre d'illumination pour l'au moins un champ.

18.  Procédé selon l'une des revendications 1 à 10, **caractérisé en ce que** ledit motif de résonateur est en métal ou alliage métallique, et **en ce que** modifier les spécifications de référence pour l'étape de lithographie à l'étape (d) comprend une étape de croissance localisée par galvanoplastie pour l'au moins un champ.

19.  Procédé selon l'une des revendications précédentes, **caractérisé en ce que** les spécifications de référence sont les mêmes pour chaque plaquette de référence.

20.  Procédé selon l'une des revendications précédentes, **caractérisé en ce que** les résonateurs comprennent de spiraux destinés chacun à équiper un balancier d'un mouvement d'horlogerie mécanique.

21.  Procédé selon l'une des revendications précédentes, **caractérisé en ce que** les résonateurs sont à base de silicium, de préférence à base de silicium monocristallin.

22.  Procédé selon l'une des revendications 1 à 20, **caractérisé en ce que** les résonateurs sont fabriqués dans des plaquettes en l'un des matériaux suivants : un matériau semiconducteur autre que le silicium, un verre, une céramique, le carbone ou un matériau composite.

**23.** Un procédé de fabrication d'une pluralité de résonateurs mécaniques (100) dans une plaquette de fabrication (10), les résonateurs étant destinés à équiper un organe régulateur d'une pièce d'horlogerie et la fabrication comprenant au moins une étape de lithographie pour former des motifs des résonateurs sur ou au-dessus ladite plaquette et une étape d'usinage dans ladite plaquette à travers desdits motifs, le procédé comprenant les étapes suivantes :

(a) établir une cartographie indicative de la dispersion de raideurs par rapport à une valeur de raideur moyenne pour des résonateurs fabriqués selon des spécifications de référence ;
(b) diviser la cartographie en des champs et déterminer une correction à implémenter aux dimensions des résonateurs pour au moins un desdits champs afin de réduire ladite dispersion ;
(c) modifier les spécifications de référence pour l'étape de lithographie afin d'implémenter les corrections aux dimensions pour ledit au moins un champ lors de l'étape de lithographie ; et
(d) fabriquer des résonateurs sur une plaquette de fabrication en utilisant les spécifications modifiées.

**24.** Procédé selon la revendication précédente, **caractérisé en ce que** modifier les spécifications de référence pour l'étape de lithographie à l'étape (c) comprend ajuster une dose d'insolation pour l'au moins un champ.

**25.** Procédé selon la revendication précédente, **caractérisé en ce que** l'étape de lithographie pour former les motifs des résonateurs utilise un système de stepper et réticule (300).

**Patentansprüche**

**1.** Verfahren zur Herstellung einer Mehrzahl von mechanischen Resonatoren (100) in einem Herstellungswafer (10), wobei die Resonatoren dazu bestimmt sind, ein Regulierorgan einer Uhr zu bestücken, wobei das Verfahren die folgenden Schritte umfasst:

(a) Herstellen einer Mehrzahl von Resonatoren in mindestens einem Referenzwafer unter Befolgung der Referenzspezifikationen, wobei diese Herstellung mindestens einen Lithografieschritt, um Muster der Resonatoren auf oder über dem Referenzwafer zu bilden, und einen Bearbeitungsschritt in dem Referenzwafer durch die Muster hindurch umfasst;
(b) für den mindestens einen Referenzwafer, Erstellen einer hinweisenden Karte der Streuung von Steifigkeiten der Resonatoren in Bezug auf einen mittleren Steifigkeitswert;
(c) Unterteilen der Karte in Felder und Bestimmen einer Korrektur, die an den Abmessungen der Resonatoren für mindestens eines der Felder zu implementieren ist, um die Streuung zu verringern;
(d) Ändern der Referenzspezifikationen für den Lithografieschritt, um die Korrekturen an den Abmessungen für das mindestens ein Feld bei dem Lithografieschritt zu implementieren;
(e) Herstellen der Resonatoren auf einem Herstellungswafer unter Verwendung der geänderten Spezifikationen.

**2.** Verfahren nach Anspruch 1, **dadurch gekennzeichnet, dass** jedes Feld mindestens einen Resonator umfasst.

**3.** Verfahren nach Anspruch 2, **dadurch gekennzeichnet, dass** jedes Feld eine Mehrzahl von Resonatoren umfasst, bevorzugt 2 bis 20 Resonatoren und noch bevorzugter 5-15 Resonatoren.

**4.** Verfahren nach einem der vorhergehenden Ansprüche, **dadurch gekennzeichnet, dass** mindestens die Mehrheit der Felder die gleiche Anzahl von Resonatoren umfasst.

**5.** Verfahren nach einem der vorhergehenden Ansprüche, **dadurch gekennzeichnet, dass** der Schritt (a) für eine Mehrzahl von Referenzwafern, bevorzugt 10 bis 30 Referenzwafer, durchgeführt wird.

**6.** Verfahren nach einem der vorhergehenden Ansprüche, **dadurch gekennzeichnet, dass** der Schritt (b) das Messen der Steifigkeiten einer Stichprobe von Resonatoren auf jedem Referenzwafer umfasst.

**7.** Verfahren nach dem vorhergehenden Anspruch, **dadurch gekennzeichnet, dass** die Stichprobe bei jedem Referenzwafer mindestens 5 %, bevorzugt mindestens 10 %, der Resonatoren auf dem Referenzwafer umfasst.

**8.** Verfahren nach einem der vorhergehenden Ansprüche, **dadurch gekennzeichnet, dass** die mittlere Steifigkeit der Karte dem Mittelwert der im Mittelpunkt jedes Referenzwafers gemessenen Steifigkeiten entspricht.

**9.** Verfahren nach einem der vorhergehenden Ansprüche, **dadurch gekennzeichnet, dass** das Ändern der Referenzspezifikationen für den Lithografieschritt im Schritt (d) es auch ermöglicht, die Verteilung der Steifigkeiten der Resonatoren auf dem Herstellungswafer zu einem Nennsteifigkeitswert hin zu verlagern.

**10.** Verfahren nach einem der vorhergehenden Ansprüche, **dadurch gekennzeichnet, dass** das Verfahren ein erneutes Mal die Schritte (a)-(e) ausführt, wobei mindestens ein im Schritt (e) hergestellter Herstellungswafer im erneuten Schritt (a) als der mindestens eine Referenzwafer genommen wird.

**11.** Verfahren nach einem der vorhergehenden Ansprüche, **dadurch gekennzeichnet, dass** das Ändern der Referenzspezifikationen für den Lithografieschritt im Schritt (d) das Anpassen einer Belichtungsdosis für das mindestens ein Feld umfasst.

**12.** Verfahren nach dem vorhergehenden Anspruch, **dadurch gekennzeichnet, dass** der Lithografieschritt zum Bilden der Muster der Resonatoren ein System mit Stepper und Fadenkreuz (300) verwendet.

**13.** Verfahren nach dem vorhergehenden Anspruch, **dadurch gekennzeichnet, dass** das Ändern der Referenzspezifikationen für den Lithografieschritt im Schritt (d) einen Schritt des Anpassens der Inline-Nennbelichtungsdosis des Systems mit Stepper und Fadenkreuz (300) für das mindestens ein Feld umfasst, um die Verteilung der Steifigkeiten der Resonatoren auf dem Herstellungswafer zu einem Nennsteifigkeitswert hin zu verlagern.

**14.** Verfahren nach einem der Ansprüche 12 und 13, **dadurch gekennzeichnet, dass** das Ändern der Referenzspezifikationen für den Lithografieschritt im Schritt (d) das Anpassen der kritischen Abmessung des Systems mit Stepper und Fadenkreuz (300) für das mindestens ein Feld umfasst.

**15.** Verfahren nach dem vorhergehenden Anspruch, **dadurch gekennzeichnet, dass** das Anpassen der kritischen Abmessung des Systems mit Stepper und Fadenkreuz (300) das Bestimmen eines Bias umfasst, das auf die Nennbelichtungsdosis für das mindestens ein Feld angewandt wird.

**16.** Verfahren nach einem der Ansprüche 1 bis 10, **dadurch gekennzeichnet, dass** der Lithografieschritt eine programmierbare Maske einsetzt und dass das Ändern der Referenzspezifikationen für den Lithografieschritt im Schritt (d) das Ändern der Abmessungen in dem die programmierbare Maske steuernden Programm für das mindestens ein Feld umfasst.

**17.** Verfahren nach einem der Ansprüche 1 bis 10, **dadurch gekennzeichnet, dass** der Lithografieschritt eine Maske, die einen Beleuchtungsfilter umfasst, und eine Belichtungsmaske einsetzt und dass das Ändern der Referenzspezifikationen für den Lithografieschritt im Schritt (d) das Auswählen und Ausrichten auf die Belichtungsmaske eines Profils des Resonators mit den korrigierten Abmessungen des Beleuchtungsfilters für das mindestens ein Feld umfasst.

**18.** Verfahren nach einem der Ansprüche 1 bis 10, **dadurch gekennzeichnet, dass** das Resonatormuster aus Metall oder Metalllegierung ist und dass das Ändern der Referenzspezifikationen für den Lithografieschritt im Schritt (d) einen Schritt des lokalisierten galvanoplastischen Aufwachsens für das mindestens ein Feld umfasst.

**19.** Verfahren nach einem der vorhergehenden Ansprüche, **dadurch gekennzeichnet, dass** die Referenzspezifikationen für jeden Referenzwafer dieselben sind.

**20.** Verfahren nach einem der vorhergehenden Ansprüche, **dadurch gekennzeichnet, dass** die Resonatoren Spiralfedern umfassen, die dazu bestimmt sind, eine Unruh eines mechanischen Uhrwerks zu bestücken.

**21.** Verfahren nach einem der vorhergehenden Ansprüche, **dadurch gekennzeichnet, dass** die Resonatoren auf Basis von Silicium sind, bevorzugt auf Basis von monokristallinem Silicium.

**22.** Verfahren nach einem der Ansprüche 1 bis 20, **dadurch gekennzeichnet, dass** die Resonatoren in Wafern aus einem der folgenden Materialien hergestellt werden: ein anderes Halbleitermaterial als Silicium, ein Glas, eine Keramik, Kohlenstoff oder ein Verbundmaterial.

**23.** Verfahren zur Herstellung einer Mehrzahl von mechanischen Resonatoren (100) in einem Herstellungswafer (10), wobei die Resonatoren dazu bestimmt sind, ein Regulierorgan einer Uhr zu bestücken, und wobei die Herstellung mindestens einen Lithografieschritt, um Muster der Resonatoren auf oder über dem Wafer zu bilden, und einen Bearbeitungsschritt in dem Wafer durch die Muster hindurch umfasst, wobei das Verfahren die folgenden Schritte umfasst:

(a) Erstellen einer hinweisenden Karte der Streuung von Steifigkeiten in Bezug auf einen mittleren Steifigkeitswert für Resonatoren, die nach Referenzspezifikationen hergestellt werden;
(b) Unterteilen der Karte in Felder und Bestimmen einer Korrektur, die an den Abmessungen der Resonatoren für mindestens eines der Felder zu implementieren ist, um die Streuung zu verringern;
(c) Ändern der Referenzspezifikationen für den Lithografieschritt, um die Korrekturen an den Abmessungen für das mindestens ein Feld bei dem Lithografieschritt zu implementieren; und (d) Herstellen der Resonatoren auf einem Herstellungswafer unter Verwendung der geänderten Spezifikationen.

24. Verfahren nach dem vorhergehenden Anspruch, **dadurch gekennzeichnet, dass** das Ändern der Referenzspezifikationen für den Lithografieschritt im Schritt (c) das Anpassen einer Belichtungsdosis für das mindestens ein Feld umfasst.

25. Verfahren nach dem vorhergehenden Anspruch, **dadurch gekennzeichnet, dass** der Lithografieschritt zum Bilden der Muster der Resonatoren ein System aus Stepper und Fotomaske (300) verwendet.

**Claims**

1. A method for producing a plurality of mechanical resonators (100) in a production wafer (10), the resonators being intended to equip a regulating organ for a timepiece, the method comprising the following steps:

    (a) producing a plurality of resonators in at least one reference wafer according to reference specifications, this production comprising at least one lithography step for forming patterns of the resonators on or above said reference wafer and a step of machining into said reference wafer through said patterns;
    (b) for the at least one reference wafer, establishing a map indicative of the dispersion of stiffnesses of the resonators relative to a mean stiffness value;
    (c) dividing the map into fields and determining a correction to be made to the dimensions of the resonators for at least one of said fields in order to reduce said dispersion;
    (d) modifying the reference specifications for the lithography step in order to implement the corrections to the dimensions for said at least one field during the lithography step;
    (e) producing resonators on a production wafer using the modified specifications.

2. Method according to Claim 1, **characterized in that** each field comprises at least one resonator.

3. Method according to Claim 2, **characterized in that** each field comprises a plurality of resonators, preferably from 2 to 20 resonators, and more preferably from 5 to 15 resonators.

4. Method according to one of the preceding claims, **characterized in that** at least the majority of fields comprise the same number of resonators.

5. Method according to one of the preceding claims, **characterized in that** step (a) is carried out for a plurality of reference wafers, preferably 10 to 30 reference wafers.

6. Method according to one of the preceding claims, **characterized in that** step (b) comprises measuring the stiffnesses of a sample of resonators on each reference wafer.

7. Method according to the preceding claim, **characterized in that**, for each reference wafer, said sample comprises at least 5%, preferably at least 10%, of the resonators on said reference wafer.

8. Method according to one of the preceding claims, **characterized in that** the mean stiffness of the map corresponds to the mean of the stiffnesses measured at the centre of each reference wafer.

9. Method according to one of the preceding claims, **characterized in that** the modification of the reference specifications for the lithography step in step (d) also makes it possible to shift the distribution of the stiffnesses of the resonators on the production wafer towards a nominal stiffness value.

10. Method according to one of the preceding claims, **characterized in that** the method carries out steps (a) to (e) again with at least one production wafer produced in step (e) taken as the at least one reference wafer in the new step (a).

11. Method according to one of the preceding claims, **characterized in that** modifying the reference specifications for the lithography step in step (d) comprises adjusting an insolation dose for the at least one field.

12. Method according to the preceding claim, **characterized in that** the lithography step for forming the patterns of the resonators uses a stepper-and-reticle system (300).

13. Method according to the preceding claim, **characterized in that** the modification of the reference specifications for the lithography step in step (d) comprises a step of adjusting the nominal on-line insolation dose of the stepper-and-reticle system (300) for the at least one field, in order to shift the distribution of the stiffnesses of the resonators on the production wafer towards a nominal stiffness value.

14. Method according to one of Claims 12 and 13, **characterized in that** modifying the reference specifications for the lithography step in step (d) comprises adjusting the critical dimension of the stepper-and-reticle system (300) for the at least one field.

15. Method according to the preceding claim, **characterized in that** adjusting the critical dimension of the stepper-and-reticle system (300) comprises determining a bias that is applied to the nominal insolation dose for the at least one field.

16. Method according to one of Claims 1 to 10, **characterized in that** the lithography step uses a programmable mask, and **in that** modifying the reference specifications for the lithography step in step (d) comprises modifying the dimensions in the program controlling the programmable mask for the at least one field.

17. Method according to one of Claims 1 to 10, **characterized in that** the lithography step uses a mask comprising an illumination filter and an exposure mask, and **in that** modifying the reference specifications for the lithography step in step (d) comprises choosing and aligning with the exposure mask a profile of the resonator at the corrected dimensions of the illumination filter for the at least one field.

18. Method according to one of Claims 1 to 10, **characterized in that** said resonator pattern is made of metal or metal alloy, and **in that** modifying the reference specifications for the lithography step in step (d) comprises a step of localized growth by electroplating for the at least one field.

19. Method according to one of the preceding claims, **characterized in that** the reference specifications are the same for each reference wafer.

20. Method according to one of the preceding claims, **characterized in that** the resonators comprise hairsprings each intended to equip a balance of a mechanical timepiece movement.

21. Method according to one of the preceding claims, **characterized in that** the resonators are silicon-based, preferably single-crystal silicon-based.

22. Method according to one of Claims 1 to 20, **characterized in that** the resonators are produced in wafers made of one of the following materials: a semiconductor material other than silicon, a glass, a ceramic, carbon or a composite material.

23. Method for producing a plurality of mechanical resonators (100) in a production wafer (10), the resonators being intended to equip a regulating organ for a timepiece and the production method comprising at least one lithography step for forming patterns of the resonators on or above said wafer and a step of machining into said wafer through said patterns, the method comprising the following steps:

   (a) establishing a map indicative of the dispersion of stiffnesses relative to a mean stiffness value for resonators produced according to reference specifications;
   (b) dividing the map into fields and determining a correction to be made to the dimensions of the resonators for at least one of said fields in order to reduce said dispersion;
   (c) modifying the reference specifications for the lithography step in order to implement the corrections to the dimensions for said at least one field during the lithography step; and
   (d) producing resonators on a production wafer using the modified specifications.

24. Method according to the preceding claim, **characterized in that** modifying the reference specifications for the lithography step in step (c) comprises adjusting an insolation dose for the at least one field.

25. Method according to the preceding claim, **characterized in that** the lithography step for forming the patterns of the resonators uses a stepper-and-reticle system (300).

FIG. 1

FIG. 2

10 {

40

30

20

FIG. 3A

50

40

30

20

FIG. 3B

50

40

30

20

## FIG. 3C

50

40

30

20

## FIG. 3D

FIG. 3E

FIG. 3F

FIG. 3G

N

Rdc1

Rd1

Rm1

R

FIG. 4

N

Rdc1

Rd1

Rnom

Rm1

R

FIG. 8

FIG. 5

FIG. 6

Fabriquer des résonateurs sur au moins une plaquette de référence en utilisant des spécifications de référence — 200

Mesurer les raideurs d'au moins un échantillon de résonateurs sur chaque plaquette de référence — 210

Etablir une cartographie de la dispersion des raideurs sur la base des raideurs mesurées en 210 — 220

Diviser la cartographie en des champs et déterminer une correction aux dimensions des résonateurs pour au moins un champ — 230

Modifier les spécifications de référence pour la lithographie afin d'implémenter les corrections déterminées à l'étape 230 — 240

Fabriquer des résonateurs sur une plaquette de fabrication en utilisant les spécifications modifiées — 250

FIG. 7

FIG. 9

## RÉFÉRENCES CITÉES DANS LA DESCRIPTION

**Documents brevets cités dans la description**

- EP 2037335 A
- EP 1422436 A
- EP 2215531 A
- WO 2016128694 A
- WO 2015113973 A
- EP 3181938 A
- EP 3181939 A
- EP 2565727 A
- WO 2019166922 A
- EP 3285124 A
- JP 2017044533 A
- EP 2753984 A
- EP 3769160 A
- EP 3769161 A
- EP 2423764 A

**Littérature non-brevet citée dans la description**

- **M. VERMOT et al.** *Traité de construction horlogère,* 2011, 178-179
- **VOELKEL et al.** Advanced mask aligner lithography : new illumination system. *Optic Express,* Septembre 2010, vol. 18
- **SINGH et al.** Scanning Probe Lithography. *Techniques used for maskless lithography, Int. Journal of Science and Research India,* Juillet 2013, vol. 2 (7